# FASCICULE DE BREVET EUROPEEN

(11) **EP 0 845 846 B1**
(45) Date de publication et mention de la délivrance du brevet: **03.01.2007**
(21) Numéro de dépôt: 97402842.5
(22) Date de dépôt: 26.11.1997
(51) Int. Cl.: H02H 1/00, G01R 15/16

(54) **Dispositif de détection et de mesure de défaut sur lignes d'alimentation électrique**
Vorrichtung zur Fehlererkennung und Messung an elektrischen Versorgungsleitungen
Device for fault detection and measurement on electrical power lines

(30) Priorité: 29.11.1996 FR 9614712
(43) Date de publication de la demande: 03.06.1998
(73) Titulaire: SORHODEL BARDIN, 01700 Beynost (FR)
(72) Inventeur: Drouere, Bernard, 28000 Chartres (FR); Richard, Philippe, 28000 Chartres (FR)
(74) Mandataire: Texier, Christian

(56) Documents cités:
- EP-A- 0 586 273
- DE-U- 8 910 945
- PATENT ABSTRACTS OF JAPAN vol. 008, no. 086 (P-269), 19 avril 1984 & JP 59 003265 A (DENRIYOKU CHUO KENKYUSHO), 9 janvier 1984,
- PATENT ABSTRACTS OF JAPAN vol. 016, no. 018 (E-1155), 17 janvier 1992 & JP 03 235616 A (SHIZUKI DENKI SEISAKUSHO:KK;OTHERS: 01), 21 octobre 1991,

## Description

La présente invention concerne le domaine des dispositifs de détection et de mesure de défaut sur les lignes d'alimentation électrique.

De nombreux dispositifs de détection, à cette fin, ont déjà été proposés.

Le document EP-0586273 décrit un dispositif de détection de défauts sur un réseau de distribution d'énergie électrique aérien comportant un circuit électronique qui reçoit un signal représentatif de la tension homopolaire et un signal représentatif du courant homopolaire de la ligne à surveiller, ledit circuit électronique effectuant une détection des variations transitoires du courant homopolaire en comparant le signe du transitoire du courant homopolaire à celui du transitoire de la tension homopolaire, caractérisé en ce que le capteur de courant homopolaire est constitué par une bobine comportant un noyau magnétique et disposée au voisinage de la ligne à surveiller perpendiculairement à celle-ci, en ce que le signal fourni par cette bobine est envoyé sur un circuit intégrateur et en ce que le capteur de tension est constitué par un capteur de champ électrique disposé à distance de la ligne sur celle-ci.

Le document JP-59003265 décrit un capteur de détection tridimensionnel de champ électrique formé par agencement de six plaques orthogonales deux à deux.

Le document EP-0267500 décrit un dispositif de surveillance de l'état de lignes électriques qui comprend notamment un filtre passe bande et un soustracteur apte à retrancher le signal de sortie du filtre passe bande du signal d'entrée.

Cependant, les dispositifs connus ne donnent pas totalement satisfaction.

La présente invention a par conséquent pour but de perfectionner les dispositifs jusqu'ici proposés.

Selon un premier aspect, la présente invention propose un dispositif de détection et de mesure de défaut sur lignes d'alimentation électrique tel que défini dans la revendication 1.

Selon un deuxième aspect, la présente invention propose un procédé de détection et de mesure de défaut sur lignes d'alimentation électrique d'un réseau d'alimentation électrique, tel que défini dans la revendication 9.

Selon d'autres aspects importants de la présente invention, il est prévu :
- un capteur de courant comportant deux bobines placées sur des noyaux magnétiques respectifs orthogonaux entre eux et des moyens aptes à opérer la sommation des signaux issus de ces deux bobines,
- des moyens d'analyse aptes à opérer simultanément une détection de dépassement de seuil sur le courant et sur la tension surveillée, et des moyens aptes à modifier le seuil de détection sur celui du courant ou de la tension n'ayant pas donné lieu à un dépassement de seuil, après détection d'un tel dépassement sur l'autre de la tension et du courant,
- de préférence, des moyens aptes à modifier le seuil de déclenchement précité par modification du gain de la branche de détection correspondante.

D'autres caractéristiques, buts et avantages de l'invention apparaîtront à la lecture de la description détaillée qui va suivre, et en regard des dessins annexés, donnés à titre d'exemples non limitatifs et sur lesquels :
- la figure 1 représente schématiquement le circuit d'un dispositif de détection conforme à la présente invention pour un réseau d'alimentation électrique souterrain,
- la figure 2 représente schématiquement le circuit d'un dispositif de détection conforme à la présente invention pour un réseau d'alimentation électrique aérien,
- la figure 3 représente des champs magnétiques résultant de défauts triphasés isolés pour différents types d'armement d'alimentation (NV2, PORTIQUE, VOUTE RIGIDE, ALTERNE A 70, DRAPEAU 105),
- la figure 4 représente le schéma d'un système d'isolation électrique pour la détection de tension, et
- les figures 5 et 6 schématisent deux modes de réalisation de capteurs de tension conformes à la présente invention.

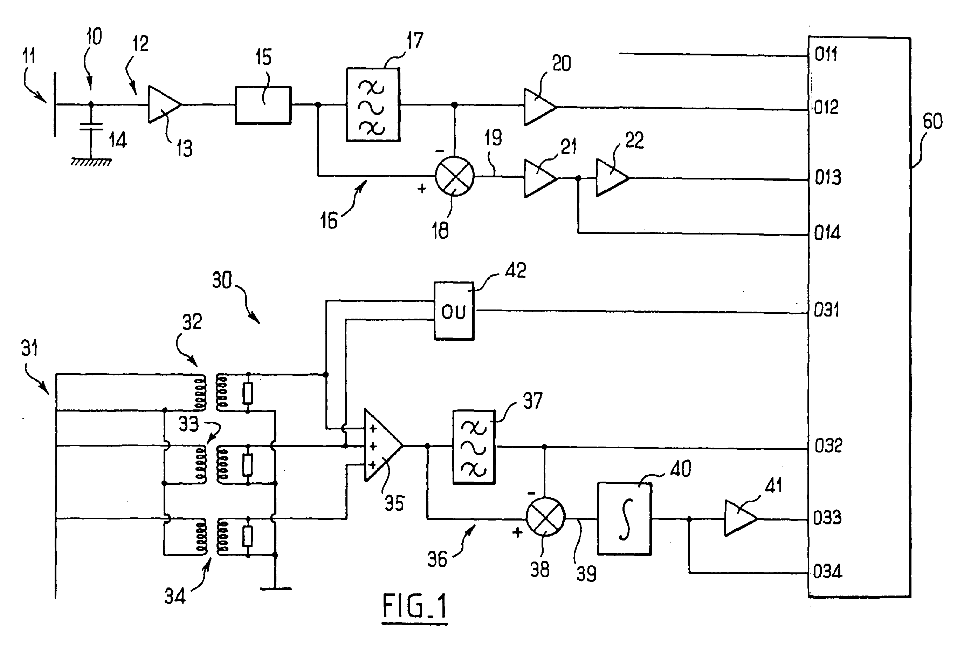

On va décrire tout d'abord, le schéma de détection pour un réseau souterrain tel qu'illustré sur la figure 1.

Ce circuit comprend deux branches principales : une branche 10 de détection de tension et une branche 30 de détection de courant.

La branche de détection de tension 10 comprend :
- un capteur 11 tel que trois condensateurs ayant un point commun, chacun étant relié à une des 3 phases du réseau d'alimentation,
- un intégrateur 12 formé d'un amplificateur 13 dont l'entrée reliée à la masse par un condensateur 14 reçoit la sortie du capteur 11,
- un filtre anti-orage 15 relié à la sortie de l'intégrateur 12 et formé par exemple d'un filtre passe bas et d'un sommateur,
- une cellule 16 d'extraction de transitoire, comprenant un filtre passe bande 17 centré sur 50Hz et un soustracteur 18, le filtre passe bande 17 étant placé entre la sortie du filtre 15 et l'entrée négative du soustracteur 18 tandis que l'entrée positive de celui-ci reçoit la sortie du filtre 15 de sorte que le soustracteur 18 par retrait du signal de base à 50Hz issu du filtre 17, extrait à sa sortie 19 les transitoires de tension,
- un amplificateur 20, par exemple de gain égal à 10, placé à la sortie du filtre 17,
- un second amplificateur 21 par exemple de gain égal à 10 placé sur la sortie du soustracteur 18, et
- un inverseur 22 de gain à égal à -1 placé à la sortie de l'amplificateur 21.

L'utilisation d'un filtre passe bande associé à un soustracteur pour extraire les transitoires, conformément à la présente invention offre par rapport à la solution retenue dans certains dispositifs connus de l'état de la technique, utilisant un filtre passe haut, les avantages suivant.

Un filtre passe haut pour extraire des transitoires présente deux inconvénients majeurs :
1) le temps de propagation de groupe d'un filtre passe haut limite en amplitude la première alternance de transitoire en fonction de la pseudofréquence de ce dernier, et
2) sur un grand nombre de défauts phases/terre, le transitoire ne se traduit pas par une augmentation en fréquence par rapport à la fréquence du réseau 50Hz, mais par une diminution en fréquence, surtout sur le signal de tension homopolaire.

Le temps de propagation de groupe d'un filtre passe bande 50Hz conforme à l'invention permet au contraire d'extraire correctement la première alternance du transitoire, qu'ils correspondent soit à une augmentation en fréquence, soit à une diminution de fréquence par rapport à la fréquence du réseau 50Hz.

D'autre part, la réjection de la fréquence fondamentale du réseau est de loin meilleure avec un filtre passe bande conforme à l'invention qu'elle ne l'est avec un filtre passe haut classique.

Cette branche 10 fournit ainsi :
- sur une première sortie O11 reliée à un capteur classique, la tension efficace à 50Hz du réseau d'alimentation (représentative soit de la tension simple à 50Hz, soit de la tension composée c'est-à-dire entre phases à 50Hz du réseau) ce signal permet de connaître l'état du réseau : hors/sous tension,
- sur une seconde sortie O12 la tension homopolaire à 50Hz (représentative de la tension homopolaire à 50Hz lors d'un défaut phases/terre) ; ce signal permet de valider un défaut phases/terre, et sur
- des sorties O13 et O14 reliées respectivement à la sortie de l'inverseur 22 et à la sortie de l'amplificateur 21, les tensions transitoires VO- et son inverse VO+ détectées sur la ligne.

La branche de détection de courant 30 comprend quant à elle :
- trois tores 31, à point commun, associés respectivement aux trois phases du réseau d'alimentation,
- trois transformateurs d'isolement 32, 33, 34 associés respectivement à ces tores et ayant pour cela leur primaire relié respectivement à la sortie des tores 31,
- un sommateur 35 dont les entrées sont reliées aux sorties des secondaires des transformateurs 32, 33, 34 ayant un point commun à la masse,
- une cellule 36 d'extraction de transitoires, comprenant un filtre passe bande 37 centré sur 50Hz et un soustracteur 38, le filtre passe bande 37 étant placé entre la sortie du sommateur 35 et l'entrée négative du soustracteur 38 tandis que l'entrée positive de celui-ci reçoit la sortie du sommateur 35 de sorte que le soustracteur 38 par retrait du signal de base à 50Hz issu du filtre 37, extrait à sa sortie 39 les transitoires de tension,
- un intégrateur 40 placé à la sortie 39 du soustracteur 38,
- un inverseur 41 ou amplificateur de gain -1 relié à la sortie de l'intégrateur 40,
- une cellule de type OU 42 à deux ou trois entrées reliées respectivement aux sorties des secondaires des transformateurs d'isolement 32, 33 et 34.

Cette branche 30 fournit ainsi :
- sur une première entrée O31 reliée à la sortie de la cellule ou 42 le signal de courant Imax à 50Hz (représentatif des courants de phases lors de défauts polyphasés isolés),
- sur une deuxième sortie 032 reliée à la sortie du filtre passe bande 37 un signal représentatif d'un courant de défaut double à 50Hz (représentatif des courants homopolaires lors de défauts biphasés/terre), et
- sur les sorties O33 et O34 reliées respectivement à la sortie de l'amplificateur inverseur 41 et à la sortie de l'intégrateur 40, le courant transitoire homopolaire 3IO- et son inverse 3IO+.

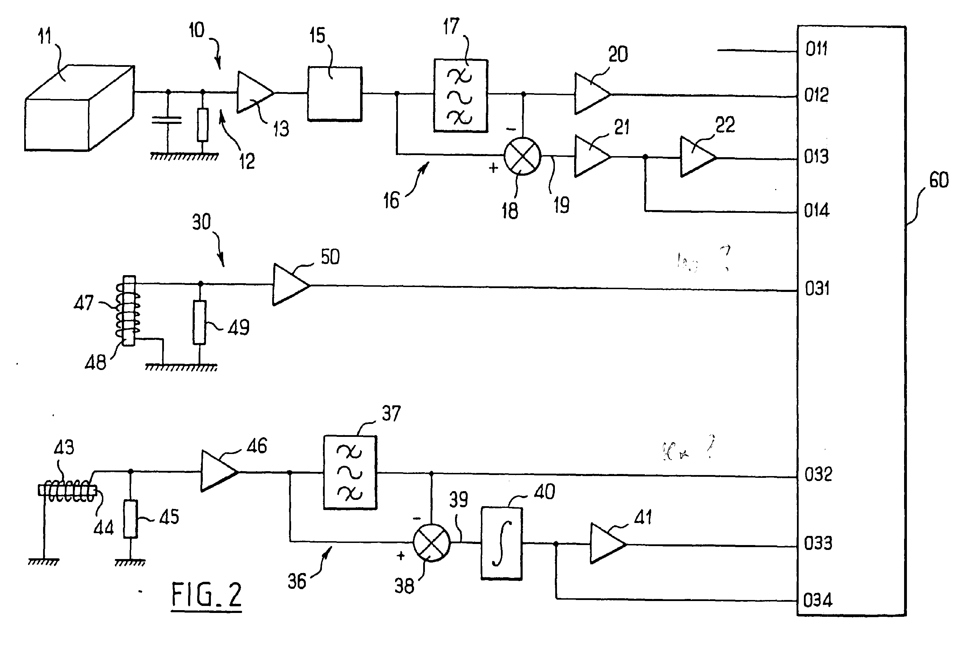

On va maintenant décrire la structure du circuit de détection pour un réseau de type aérien illustré sur la figure 2.

Ce circuit de la figure 2 comprend également une branche 10 de détection de tension et une branche 30 de détection de courant.

On retrouve sur la figure 2, pour la branche de détection de tension 10, un intégrateur 12, un filtre anti-orage 15, une cellule 16 d'extraction de transitoire comprenant un filtre passe bande 17 et un soustracteur 18, ainsi que deux amplificateurs 20 et 21 et un amplificateur inverseur 22 conformes aux dispositions précédemment décrites en regard de la figure 1. La branche 10 illustrée sur la figure 2 se distingue de celle de la figure 1 précédemment décrite par le fait que le capteur 11 placé à proximité des lignes aériennes est formé d'un moyen apte à opérer la somme vectorielle de champs électriques dans plusieurs directions, par exemple par un élément électriquement conducteur équipotentiel non planaire.

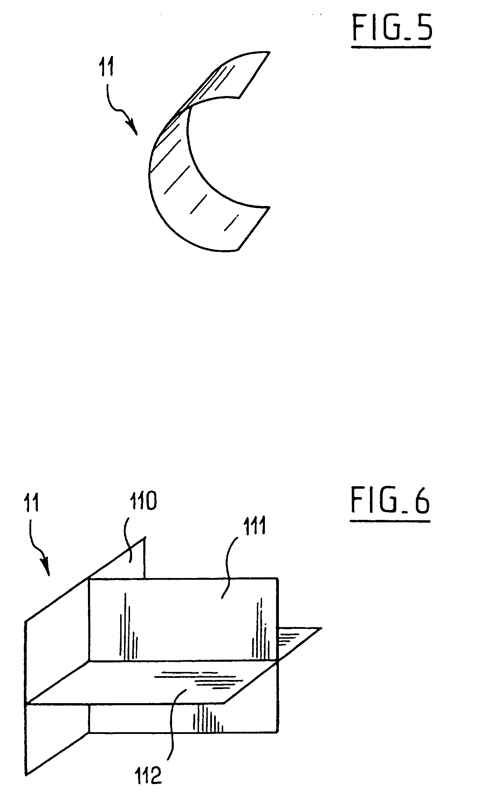

On a illustré sur les figures 5 et 6 deux exemples non limitatifs de réalisation d'un tel capteur équipotentiel non plan.

Plus précisément, on a illustré sur la figure 5 un capteur 11 formé d'une feuille, par exemple en métal, de forme curviligne, de préférence sous forme d'un secteur de cylindre de révolution, par exemple d'un hémicylindre.

Par ailleurs on a illustré sur la figure 6, un capteur 11 formé par assemblage de trois feuilles planes 110, 111, 112, reliées entre elles et orthogonales deux à deux. Selon la figure 6, ces feuilles 110, 111, 112 se raccordent sensiblement à mi-largeur. En variante, on pourrait prévoir des feuilles 110, 111, 112, qui se raccordent par leurs arêtes à la façon d'une portion de quadrilatère.

Pour obtenir une sommation vectorielle des champs dans trois directions, les feuilles 110, 111 et 112 ont des surfaces respectives identiques.

Une telle branche de détection 10 délivre sur ses sorties O11, O12, O13 et O14 des signaux de même nature que la branche 10 précédemment décrite en regard de la figure 1.

La branche de détection de courant 30 illustrée sur la figure 2 comprend également une cellule 36 de détection de transitoire comportant un filtre passe bande 37 associé à un soustracteur 38, un intégrateur 40 et un amplificateur inverseur 41. Cependant, la branche 30 de la figure 2 comprend une bobine 43 placée sur un noyau magnétique 44 orthogonal aux lignes, et de préférence horizontal, connectée en parallèle d'une résistance 45, entre la masse et la borne d'entrée d'un amplificateur 46 dont la sortie attaque l'entrée de la cellule 36 d'extraction de transitoire, c'est-à-dire l'entrée du filtre 37 et l'entrée positive du soustracteur 38.

En outre, la branche 30 de la figure 2 pour réseaux aériens comprend une seconde bobine 47 placée sur un noyau magnétique 48 orthogonal au noyau 44 et aux lignes électriques et de préférence vertical, connectée en parallèle d'une résistance 49 entre la masse et l'entrée d'un amplificateur 50.

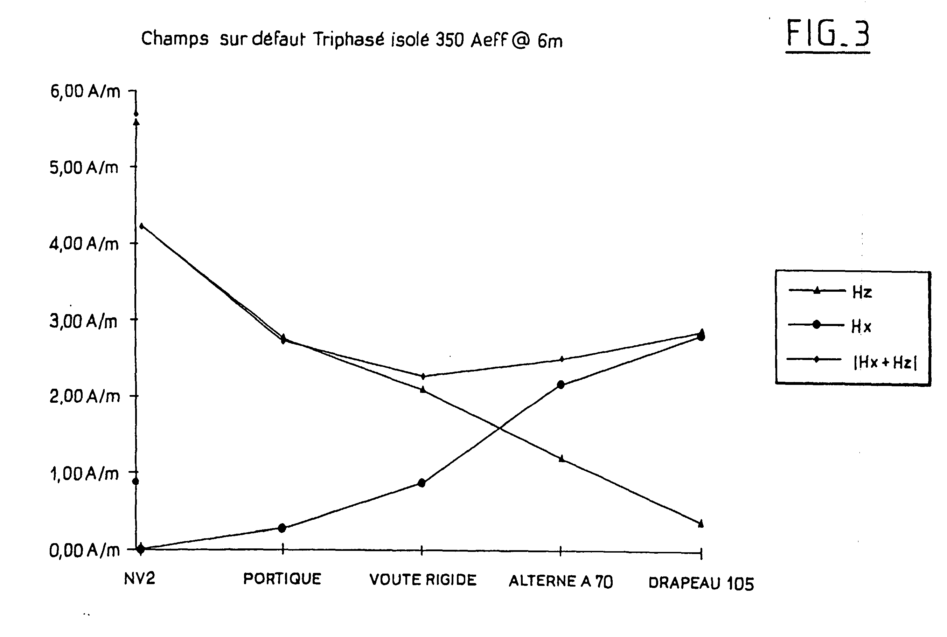

La branche 30 de la figure 2 fournit sur ces sorties O33 et O34 le courant transitoire homopolaire 3IO- et son inverse 3IO+, comme décrit précédemment pour la figure 1. La branche 30 de la figure 2 délivre sur les sorties O31 et O32 reliées à la sortie de l'amplificateur 50 et à la sortie du filtre 37 des signaux représentatifs respectivement du champ magnétique horizontal Hx et du champ magnétique vertical Hz. La sommation des signaux issus de ces deux sorties O31 et O32 permet d'obtenir un signal représentatif de Hx+Hz bien représentatif des défauts triphasés isolés, quelle que soit l'architure du réseau d'alimentation. En effet, comme on l'a montré sur la figure 3, qui illustre respectivement sur trois tracets différents le champ horizontal Hx, le champ vertical Hz et la somme de ces deux champs Hx et Hz, alors que le champ horizontal Hx et le champ vertical Hz sont chacun susceptibles de fortes évolutions selon l'architecture retenue, il s'avère que la sommation de ces champs Hx et Hz présentent une relative constance quelle que soit l'architecture ou armement du réseau d'alimentation retenue.

Les branches 10 et 30 des circuits illustrés sur les figures 1 et 2 fournissent grâce aux amplificateurs inverseurs 22 et 41 des valeurs transitoires V0-, 310- et leur inverse V0+ et 310+ pour permettre au circuit de traitement et de détection situé en aval de ne retenir que les valeurs positives du signal délivré.

Le circuit de traitement aval schématisé sous le bloc fonctionnel 60 sur les figures 1 et 2, opère la comparaison du signe des transitoires de tension homopolaire et du signe de l'intégrale des transitoires de courant homopolaire.

En effet, sur un départ en défaut, l'intégrale des transitoires de courant homopolaire est de signe opposé à l'intégrale des transitoires de courant homopolaire des départs sains. De plus, la variation instantanée de la tension homopolaire se fait dans le même sens que l'intégrale de la variation de courant sur les départs sains.

Plus précisément, la Demanderesse a constaté que pour un réseau d'alimentation impédant, les transitoires de courant sont élevés tandis que les transitoires de tension sont faibles, et inversement pour un réseau d'alimentation compensé, les transitoires de tension sont élevés et les transitoires de courant sont faibles.

Pour permettre la réalisation d'un circuit de détection quasi-universel, c'est-à-dire applicable à tout type de réseau d'alimentation électrique, qu'il soit impédant ou compensé, il est proposé dans le cadre de l'invention que la fenêtre d'analyse par comparaison des signes des transitoires de tension homopolaire et de l'intégrale des transitoires de courant homopolaire soit déclencheé, soit par le dépassement d'un seuil par les transitoires en tension homopolaire (signal disponible sur les sorties O13 et O14), soit par le dépassement d'un seuil par l'intégrale des transitoires de courant homopolaire (signal disponible sur les sorties O33 et O34). De plus, le circuit de traitement 60 est adapté pour modifier le seuil de détection pour la grandeur physique qui n'est pas à l'origine du déclenchement, par exemple en abaissant son seuil de transitoire d'un facteur quatre. En pratique, cette modification de seuil de déclenchement peut être opérée par modification du gain d'amplification du signal correspondant.

En d'autres termes, lorsque le circuit de traitement 60 détecte un dépassement de seuil sur la transitoire de tension homopolaire il déclenche la fenêtre d'analyse des signes et réduit le seuil de déclenchement sur l'intégrale des transitoires de courant homopolaire. Et inversement, lorsque le circuit de traitement 60 détecte un dépassement de seuil sur l'intégrale des transitoires de courant homopolaire, il déclenche la fenêtre d'analyse des signes et réduit le seuil de déclenchement sur les transitoires de tension homopolaire.

Les signaux de tension et de courant disponibles sur les sorties O11, O12, O31 et O32 permettent par contrôle classique une validation des défauts détectés.

Plus précisément encore, dans le cadre de la présente invention, le circuit de traitement 60 opère de préférence les détections suivantes :
a) défaut homopolaire :
   - détermination du sens du défaut par comparaison des signes des signaux issus des sorties O13, O14 et O33, O34, le défaut homopolaire étant localisé en aval du point de détection pour une opposition de signe ou phases entre ces signaux, et étant localisé en amont pour des signaux en phases,
   - validation de la détection d'un tel défaut par dépassement d'un seuil du signal issu de la sortie O12, et
   - suppression du défaut lors du retour à la normale du signal issu de la sortie O11,
b) défaut Imax (formé typiquement par un défaut entre phases isolées) :
   - détermination par détection de dépassement du seuil du signal issu de la sortie O31, et
   - suppression du défaut lors du retour à la normale du signal issu de la sortie O11,
c) défaut double :
   - détermination par détection de dépassement du seuil du signal issu de la sortie O32, et
   - suppression du défaut lors du retour à la normale du signal issu de la sortie 011.

L'obtention d'un signal représentatif de la sommation des trois champs électriques, comme grandeur physique d'asservissement à la sortie du capteur 11 pour un réseau de type aérien permet au circuit d'être compatible quel que soit l'armement retenu ou le type de poteau, bois ou béton supportant la ligne. De même, l'exploitation de la sommation des champs magnétiques Hx + Hz permet un circuit compatible en seuil quels que soient les armements, pour les défauts polyphasés isolés.

Selon une autre caractéristique avantageuse de l'invention, il est prévu une isolation galvanique sur la branche de détection de tension homopolaire.

De nombreuses structures ont déjà été proposées pour réaliser une telle isolation galvanique. On a par exemple proposé :
- des systèmes à double transformateur, l'un permettant la transmission d'une puissance électrique d'alimentation dans un sens, l'autre d'un signal basse fréquence modulé ou non,
- des systèmes comprenant un optocoupleur pour la transmission du signal basse fréquence et un transformateur pour la transmission de la puissance électrique d'alimentation,
- ou encore un transformateur simple pour la transmission du signal, si l'énergie de celui-ci le permet.

Ces solutions connues ne donnent cependant pas satisfaction pour un signal de tension homopolaire issu d'un diviseur capacitif HTA.

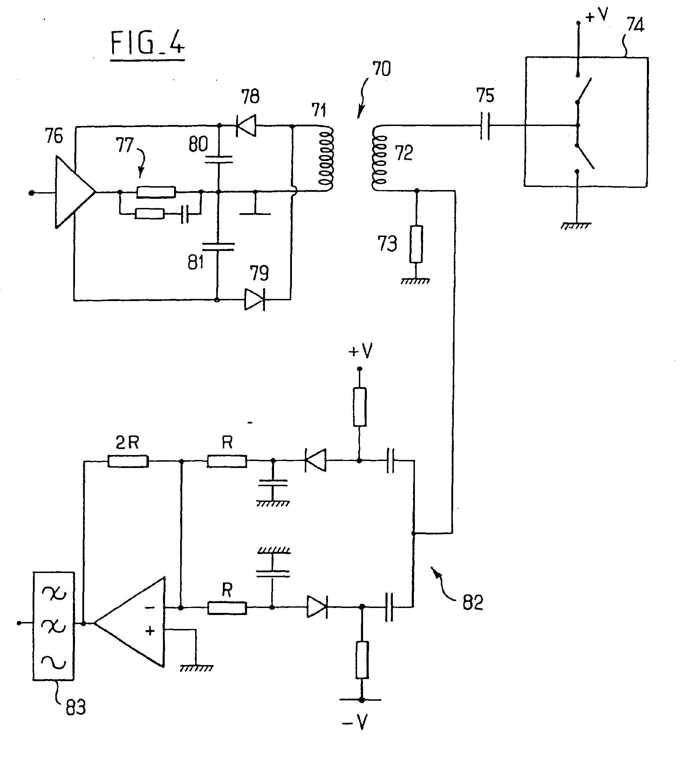

Pour résoudre cette difficulté, il est proposé dans le cadre de l'invention d'utiliser un circuit d'isolation du type illustré sur la figure 4 annexée.

Ce circuit d'isolation comprend un transformateur 70 unique qui sert à la fois à véhiculer la puissance électrique d'alimentation dans un sens et le signal utile dans l'autre. Pour cela, le secondaire 72, par exemple à N spires a une borne reliée à la masse par une résistance 73 et sa seconde borne reliée à la sortie d'un hacheur HF 74 par l'intermédiaire d'un condensateur 75. Ainsi, le signal HF issu du hacheur 74 est transmis au primaire 71, par exemple à deux N spires. Un amplificateur 76 reçoit sur son entrée le signal issu du capteur de tension et a sa sortie reliée par une impédance 77, constituée par exemple d'un réseau RC en parallèle d'une résistance, à une borne du primaire 71, pour faire varier le courant dans celui-ci. Le signal HF aux bornes du primaire 71 est redressé par l'intermédiaire de deux diodes 78, 79 et filtré par les condensateurs 80, 81 afin d'alimenter l'amplificateur 76. Le transformateur 70 permet ainsi de transmettre du primaire 71 vers le secondaire 72 un signal électrique BF issu du capteur, modulé par la HF. Ce signal modulé est récupéré sur la résistance shunt 73 et dirigé vers un circuit de démodulation 82 associé à un filtre 83 avant traitement.

Le circuit d'isolation représenté sur la figure 4 présente typiquement les caractéristiques suivantes :
- bande passante : 25Hz - 500Hz (déphasage < 5° dans la bande)
- fréquence hacheur: 50KHz à rapport cyclique 50%
- filtre passe bas : 5KHz du deuxième ordre
- consommation : < 10mA sous 12 Volts.

En particulier, la présente invention n'est pas limitée à l'utilisation d'un capteur 11 de tension équipotentiel de géométrie tridimensionnelle.

En variante dans le cadre de la présente invention, le capteur de tension équipotentiel 11 peut être formé d'une plaque plane équipotentielle en matériau électriquement conducteur.

En effet de façon à priori surprenante les inventeurs ont constaté qu'une plaque plane unique permettait également de délivrer un signal représentatif de la sommation vectorielle des composants tridimensionnelles du champ électrique. Ceci est du semble-t-il au fait que quelque soit l'orientation initiale du champ électrique, les lignes de champ se réorientent perpendiculairement à une plaque électriquement conductrice, au voisinage de celle-ci.

## Revendications

1. Dispositif de détection et de mesure de défaut sur lignes d'alimentation électriques, comprenant des moyens d'extraction de transitoires de tension et courant homopolaire sur les signaux d'alimentation comportant un filtre passe bande (17, 37), un soustracteur (18, 38) apte à retrancher le signal de sortie du filtre passe bande du signal d'alimentation pour obtenir les transitoires recherchés, et des moyens (60) aptes à comparer le signe des transitoires de tension homopolaire avec le signe d'un signal lié aux transitoires de courant homopolaire, dans lequel le signal lié aux transitoires de courant homopolaire est l'intégrale, des transitoires de courant homopolaire **caractérisé par le fait qu'**il comprend des moyens (60) d'analyse aptes à opérer simultanément une détection de dépassement de seuil sur l'intégrale des transitoires de courant et sur les transitoires de tension surveillée et des moyens (60) aptes à modifier le seuil de détection sur celui de l'intégrale des transitoires de courant ou des transitoires de tension n'ayant pas donné lieu à un dépassement de seuil, après détection d'un tel dépassement sur l'autre seuil de la tension ou du courant.

2. Dipositif selon la revendication 1, **caractérisé par le fait qu'**il comprend un capteur de tension (11) comprenant une plaque équipotentielle en matériau électriquement conducteur formant capteur multidirectionnel.

3. Dispositif selon la revendication 2, **caractérisé par le fait que** la plaque est curviligne.

4. Dispositif selon la revendication 2, **caractérisé par le fait que** la plaque est plane.

5. Dispositif selon l'une des revendications 1 à 4, **caractérisé par le fait qu'**il comprend un capteur de courant comportant deux bobines (43, 47) placées sur des noyaux magnétiques (44, 48) respectifs orthogonaux entre eux et des moyens (60) aptes à opérer la sommation des signaux issus de ces deux bobines.

6. Dispositif selon la revendication 5, **caractérisé par le fait que** les deux noyaux magnétiques (44, 48) sont respectivement horizontal et vertical.

7. Dispositif selon l'une des revendication 1 à 6, **caractérisé par le fait qu'**il comprend des moyens (60) aptes à modifier le seuil de déclenchement précité par modification du gain de la branche de détection correspondante.

8. Dispositif selon l'une des revendications 1 à 7. **caractérisé par le fait qu'**il comprend des moyens d'isolation galvanique sur une branche de détection de tension homopolaire comprenant un transformateur (70) de transfert de puissance issue d'un hacheur (74) et de transfert du signal modulé par une tension représentative de la tension du réseau d'alimentation, dont le secondaire (72) est relié à un démodulateur (82).

9. Procédé de détection et de mesure de défaut sur lignes d'alimentation électrique d'un réseau d'alimentation électrique que consiste à utiliser un capteur de tension (11) comprenant une plaque équipotentielle en matériau électriquement conducteur formant capteur multidirectionnel placée á proximité des lignes d'alimentation électrique pour opérer la somme vectorielle des champs électriques dans plusieurs directions, à extraire des transitoires de tension et courant homopolaire, sur les signaux d'alimentation à l'aide d'un filtre passe bande (17, 37), d'un soustracteur (18, 38) apte a retrancher le signal de sortie du filtre passe bande du signal d'alimentation pour obtenir les transitoires recherchées, et de moyens (60) aptes à comparer le signe des transitoires de tension homopolaire avec le signe d'un signal lié aux transitoires de courant homopolaire, dans lequel le signal lié aux transitoires de courant homopolaire est l'intégrale des transitoires de courant homopolaire, **caracterisé par le fait qu'**il consiste à opérer simultanément une détection de dépassement de seuil sur l'intégrale des transitoires de courant ou sur les transitoires de tension surveillée et à modifier le seuil de détection sur celui de l'intégrale des transitoires de courant ou des transitoires de tension n'ayant pas donné lien à un dépassement de seuil après détection d'un tel dépassement sur l'autre seuil de la tension ou du courant.

10. Procédé selon la revendication 9, **caractérisé par le fait qu'**il comprend l'étape de sommation des signaux issus de deux bobines (43, 47) placées sur des noyaux magnétiques respectifs (44, 48) orthogonaux entre eux, formant capteur de courant.

11. Procédé selon l'une des revendication 9 ou 10, **caractérisé par le fait que** l'étape de modification du seuil de déclenchement précité est opérée par modification du gain de la branche de détection correspondante.

12. Procédé selon l'une des revendications 9 à 11, **caractérisé par le fait qu'**il comprend l'étape consistant à comparer le signe des transitoires de tension homopolaire avec le signe de l'intégrale des transitoires de courant homopolaire.

## Claims

1. Device for fault detection and measurement on electrical power supply lines comprising means for extracting homopolar voltage and current transients on the power supply signals comprising a bandpass filter (17, 37), a subtractor (18, 38) capable of separating the output signal of the bandpass filter from the power supply signal in order to obtain the transients sought, and means (60) designed to compare the sign of the homopolar voltage transients with the sign of a signal associated with the homopolar current transients, in which the signal associated with the homopolar current transients is the integral of the homopolar currant transients, **characterized in that** it comprises means (60) of analysis designed to simultaneously carry out a threshold overshoot detection operation on the currant transient integral and on the monitored voltage transients and means (60) designed to modify the detection threshold on that of the integral of the current transients or of the voltage transients not having produced a threshold overshoot, after detection of such an overshoot on the other voltage or current threshold.

2. Device according to Claim 1, **characterized in that** it comprises a voltage sensor (11) comprising an equipotential plate of conducting material forming a multidirectional sensor.

3. Device according to Claim 2, **characterized in that** the plate is curvilinear.

4. Device according to Claim 2, **characterized in that** the plate is plane.

5. Device according to one of Claims 1 to 4, **characterized in that** it comprises a current detector comprising two coils (43, 47) placed over respective magnetic cores (44, 48) that are orthoganl to one another and means (60) designed to perform a summation operation on the signals coming from these two coils.

6. Device according to Claim 5, **characterized in that** the two magnetic cores (44, 48) are horizontal and vertical, respectively.

7. Device according to one of Claims 1 to 6, **characterized in that** it comprises means (60) designed to modify the aforementioned trigger threshold by modifying the gain of the corresponding detection branch.

8. Device according to one of Claims 1 to 7, **characterized in that** it comprises galvanic isolation means on a branch of homopolar voltage detection comprising a transformer (70) for the transfer of power coming from a chopper (74) and for the transfer of the modulated signal by a voltage representative of the power supply grid voltage, whose secondary (72) is connected to a demodulator (82).

9. Method for the detection and measurement of faults on electrical power supply lines of an electrical power supply grid which consists in using a voltage sensor (11) comprising an equipotential plate of electrically-conductive material forming a multidirectional sensor placed near to the electrical power supply lines in order to perform the vector sum operation on the electric fields in several directions, in extracting homopolar voltage and current transients on the power signals by means of a bandpass filter (17, 37), of a subtractor (18, 38) capable of separating the output signal of the bandpass filter from the power supply signal in order to obtain the transients sought, and means (60) designed to compare the sign of the homopolar voltage transients with the sign of a signal associated with the homopolar current transients, in which the signal associated with the homopolar current transients is the integral of the homopolar currant transients, **characterized in that** it consists in simultaneously carrying out a threshold overshoot detection operation on the currant transient integral or on the monitored voltage transients and in modifying the detection threshold on that of the integral of the current transients or of the voltage transients not having produced a threshold overshoot, after detection of such an overshoot on the other voltage or current threshold.

10. Method according to Claim 9, **characterized in that** it comprises the step for the summation of the signals coming from two coils (43, 47) placed over two respective magnetic cores (44, 48) that are orthogonal to one another, forming a current sensor.

11. Method according to either of Claims 9 and 10, the aforementioned step for the trigger modification is carried out by modifying the gain of the corresponding detection branch.

12. Method according to one of Claims 9 to 11, **characterized in that** it comprises the step consisting in comparing the sign of the homopolar voltage transients with the sign of the integral of the homopolar current transients.

## Patentansprüche

1. Vorrichtung zur Fehlerdetektierung und -messung auf Stromversorgungsleitungen, umfassend Mittel zur Gewinnung von Unipolarspannungsstößen und Unipolarstromstößen auf den Versorgungssignalen, welche einen Bandpassfilter (17,37) und einen Subtrahierer (18,38) umfassen, der geeignet ist, das Ausgangssignal des Bandpassfilters vom Versorgungssignal abzuziehen, um die gesuchten Stöße zu erhalten und Mittel (60), die geeignet sind, das Vorzeichen der Unipolarspannungsstöße mit dem Vorzeichen eines zu den Unipolarstromstößen gehörenden Signals zu vergleichen, wobei das zu den Unipolarstromstößen gehörende Signal das Integral der Unipolarstromstöße ist,
**dadurch gekennzeichnet, dass** sie Analysemittel (60) umfasst, die geeignet sind, gleichzeitig eine Detektierung einer Schwellwertüberschreitung auf dem Integral der Stromstöße und auf den Stößen überwachter Spannung durchzuführen, und Mittel (60), die geeignet sind, den Detektierungsschwellwert für denjenigen Schwellwert des Integrals der Stromstöße oder der Spannungsstöße zu ändern, für den keine Schwellwertüberschreitung verursacht worden ist, nach Detektierung einer solchen Überschreitung über den anderen Schwellwert der Spannung oder des Stroms.

2. Vorrichtung gemäß Anspruch 1, **dadurch gekennzeichnet, dass** sie einen Spannungssensor (11) umfasst, welcher eine Äquipotentialplatte aus elektrisch leitendem Material umfasst, die einen in mehreren Richtungen wirkenden Sensor bildet.

3. Vorrichtung gemäß Anspruch 2, **dadurch gekennzeichnet, dass** die Platte gekrümmt ist.

4. Vorrichtung gemäß Anspruch 2, **dadurch gekennzeichnet, dass** die Platte eben ist.

5. Vorrichtung gemäß einem der Ansprüche 1 bis 4, **dadurch gekennzeichnet, dass** sie einen Stromsensor umfasst, der zwei Spulen (43, 47) umfasst, die auf zueinander orthogonalen Magnetkernen (44,48) platziert sind, und Mittel (60), die geeignet sind, die Summierung der aus diesen beiden Spulen stammenden Signale durchzuführen.

6. Vorrichtung gemäß Anspruch 5, **dadurch gekennzeichnet, dass** die beiden Magnetkerne (44,48) jeweils horizontal und vertikal sind.

7. Vorrichtung gemäß einem der Ansprüche 1 bis 6, **dadurch gekennzeichnet, dass** sie Mittel (60) umfasst, die geeignet sind, die oben genannte Auslöseschwelle durch Verändern der Verstärkung des entsprechenden Detektierungszweiges zu ändern

8. Vorrichtung gemäß einem der Ansprüche 1 bis 7, **dadurch gekennzeichnet, dass** sie Mittel zur galvanischen Isolierung auf einem Zweig zur Detektierung der unipolaren Spannung umfasst, welcher einen Transformator (70) umfasst zur Übertragung von aus einem Zerhacker (74) stammender Leistung und zur Übertragung des Signals, das durch eine die Spannung des Versorgungsnetzes repräsentierende Spannung moduliert ist, und dessen Sekundärwicklung (72) mit einem Demodulator (82) verbunden ist.

9. Verfahren zur Fehlerdetektierung und -messung auf Stromversorgungsleitungen eines Stromversorgungsnetzes, welches umfasst
Verwenden eines Spannungssensors (11), welcher eine Äquipotentialplatte aus elektrisch leitendem Material umfasst, das einen in mehrere Richtungen wirkenden Sensor bildet, der nahe der Stromversorgungsleitungen platziert ist, um die elektrischen Felder in mehreren Richtungen vektoriell zu summieren,
Gewinnen von Unipolarspannungsstößen und Unipolarstromstößen auf den Versorgungssignalen anhand eines Bandpassfilters (17,37), eines Subtrahierers (18,38), der geeignet ist, das Ausgangssignal des Bandpassfilters vom Versorgungssignal abzuziehen, um die gesuchten Stöße zu erhalten, und Mittel (60), die geeignet sind, das Vorzeichen der Unipolarspannungsstöße mit dem Vorzeichen eines zu den Unipolarstromstößen gehörenden Signals zu vergleichen, wobei das zu den Unipolarstromstößen gehörende Signal das Integral der Unipolarstromstöße ist,
**dadurch gekennzeichnet, dass** es umfasst,
gleichzeitiges Durchführen einer Detektierung einer Schwellwertüberschreitung auf dem Integral der Stromstöße oder auf den Stößen überwachter Spannung, und
Ändern des Detektierungsschwellwerts für denjenigen Schwellwerts des Integrals der Stromstöße oder der Spannungsstöße, für den keine Schwellwertüberschreitung verursacht worden ist, nach Detektierung einer solchen Überschreitung über die andere Schwelle der Spannung oder des Stroms.

10. Verfahren gemäß Anspruch 9, **dadurch gekennzeichnet, dass** es den Schritt der Summierung der Signale umfasst, die aus zwei Spulen (43,44) stammen, die auf zueinander orthogonalen Magnetkernen (44,48) platziert sind und einen Stromsensor bilden.

11. Verfahren gemäß einem der Ansprüche 9 oder 10, **dadurch gekennzeichnet, dass** der Veränderungsschritt des oben genannten Auslöseschwellwerts durch Veränderung der Verstärkung des entsprechenden Detektierungszweigs durchgeführt wird.

12. Verfahren gemäß einem der Ansprüche 9 bis 11, **dadurch gekennzeichnet, dass** es den Schritt umfasst, das Vorzeichen der Unipolarspannungsstöße mit dem Vorzeichen des Integrals der Unipolarstromstöße zu vergleichen.
